# DEMANDE DE BREVET EUROPEEN

(11) **EP 0 636 709 A1**
(43) Date de publication de la demande: **01.02.1995**
(21) Numéro de dépôt: 94401704.5
(22) Date de dépôt: 25.07.1994
(51) Int. Cl.: C23C 28/02, C23C 14/02, C23C 14/16, C23C 14/22, C23C 16/14

(54) **Procédé de traitement de surface de pièces métalliques**

(30) Priorité: 28.07.1993 FR 9309304
(71) Demandeur: SOLLAC, F-92800 Puteaux (FR)
(72) Inventeur: Guesdon, Philippe, F-75018 Paris (FR); Choquet, Patrick, F-42100 Saint Etienne (FR); Le Duc, Hiep, F-57000 Metz (FR); Chabrol, Claude, F-69700 Givors (FR); Deparis, Didier, F-57130 Vaux (FR); Delobel, Philippe, F-60100 Creil (FR); Schuster, Frédéric, F-78100 St Germain en Laye (FR); Piet, Gérard, F-91870 Beson (FR)
(74) Mandataire: Polus, Camille

(57) **Abrégé**

Suivant ce procédé de traitement de surface, on dépose sous vide sur au moins une face de la pièce métallique revêtue de zinc, un film mince de chrome ou d'alliage de chrome, d'épaisseur au plus égale à 1 µm environ. Le dépôt sous vide peut être effectué par voie chimique ou physique ; avantageusement, simultanément au dépôt du film mince de chrome ou d'alliage de chrome, on procède à un bombardement ionique de la face de la pièce métallique revêtue de zinc dans un gaz ou un mélange gazeux formé d'au moins un gaz neutre et/ou au moins un gaz réactif. Ce procédé améliore la résistance du zinc à la corrosion en vue d'un dépôt ultérieur tel que mise de la pièce en peinture, tout en supprimant toute pollution de l'environnement grâce à l'élimination des ions chromates de l'atmosphère environnante.

## Description

La présente invention a pour objet un traitement de surface de pièces métalliques revêtues de zinc ou d'alliage de zinc, telles que des tôles d'acier.

On sait que jusqu'à présent les tôles d'acier zinguées, en particulier non alliées, formées par galvanisation à chaud ou par électrodéposition, sont soumises à un traitement de chromatation, par exemple par trempage dans une solution liquide contenant notamment des ions chromates Cr⁶⁺ au cours duquel se produit une réaction chimique entre le chrome et le zinc, provoquant la passivation du zinc.

Cette couche de conversion à base de chromates contient environ 20 à 100 mg/m² de chrome, ces limites étant dictées notamment par le risque d'une perte d'adhérence et d'un changement de couleur de la couche de chromate au-delà de 100 mg/m², et d'un mouillage insuffisant de cette couche en dessous de 20 mg/m².

En vue d'obtenir une couche plus adhérente, on sait également soumettre une tôle galvanisée à un traitement d'électrochromage tel que décrit dans le brevet FR-A-1 572 638.

Cependant, ces traitements de chromatation ou d'électrochromage présentent le grand inconvénient d'être toxiques en raison de la présence des ions de chrome et particulièrement l'ion chromate Cr⁶⁺ qui est cancérigène.

En outre, le traitement de chromatation a un effet passivant mais n'a pas d'effet barrière contribuant à rendre étanche la couche de conversion à base de chromates, et ainsi à protéger de manière durable les tôles d'acier zinguées de la corrosion atmosphérique.

En effet, on s'est aperçu que les traitements de chromatation et d'électrochromage sont des procédés qui permettent de lutter efficacement contre la rouille blanche, mais qui ne permettent pas de lutter contre l'apparition de la rouille rouge.

Or ce phénomène est particulièrement préjudiciable pour certaines applications, comme par exemple les carrosseries de véhicules automobiles.

Pour remédier à cet inconvénient, les industriels ne peuvent se contenter d'un simple traitement de chromatation, et sont donc amenés à déposer un revêtement organique, tel qu'un vernis, sur les tôles d'acier zinguées passivées par ledit traitement de chromatation.

Les tôles ainsi revêtues sont alors protégées de manière efficace et durable contre la corrosion, mais cette succession de traitements s'avère longue et complexe et par conséquent coûteuse.

On a également constaté que dans le cas où le revêtement de chrome, éventuellement renforcé du revêtement organique, était fissuré, notamment après déformation de la tôle zinguée ou par blessure accidentelle, la tôle d'acier zinguée n'était plus protégée contre la corrosion à l'endroit de la fissure.

Par ailleurs, l'évolution technologique conduit les industriels à accroître les performances de leurs produits et notamment des tôles d'acier zinguées.

Ainsi, on cherche par exemple à augmenter la dureté superficielle et à diminuer le coefficient de frottement d'une tôle d'acier zinguée afin de faciliter sa mise en forme ultérieure.

En vue de leur utilisation finale, l'aspect du produit après peinture est également d'importance. Or, les tôles d'acier zinguées, notamment alliées, qui sont mises en peinture par cataphorèse sans traitement préalable, notamment de chromatation, d'électrochromage ou d'application de revêtement organique, présentent de nombreux défauts dans la couche de peinture, dus au phénomène de cratérisation qui se produit au cours de l'étape de cataphorèse, notamment lors de l'application de tension électrique de cataphorèse élevée.

On recherche également de nouveaux types de revêtement destinés à protéger contre la corrosion d'une manière au moins aussi efficace qu'auparavant les tôles d'acier zinguées, mais dont l'épaisseur peut être réduite.

Il convient de noter que les problèmes et propriétés physiques recherchées évoqués ci-dessus concernent également, d'une manière générale, des pièces métalliques revêtues de zinc ou d'un alliage de zinc.

La présente invention a pour but de remédier aux inconvénients de l'art antérieur en proposant un traitement de surface de pièces métalliques, notamment de tôles d'acier, revêtues de zinc ou d'alliage de zinc, par application d'un revêtement superficiel, qui soit non polluant, permette de lutter efficacement contre l'apparition de la rouille rouge même en cas de fissuration dudit revêtement, évite les défauts de cratérisation après mise en peinture par cataphorèse, augmente la dureté superficielle et diminue le coefficient de frottement desdites pièces métalliques.

La présente invention a donc pour objet un traitement de surface de pièces métalliques telles que des tôles d'acier revêtues de zinc ou d'alliage de zinc, selon lequel on dépose sous vide, sur au moins une face de la pièce métallique, un film mince de chrome ou d'alliage de chrome, d'épaisseur au plus égale à 1 µm.

L'invention a également pour objet l'utilisation de ce traitement pour procurer à une pièce métallique revêtue de zinc ou d'alliage de zinc les propriétés exposées précédemment, notamment une résistance à la corrosion améliorée.

L'invention a en outre pour objet des procédés de transformation d'une pièce métallique revêtue de zinc ou d'alliage de zinc, mettant en oeuvre ledit traitement dans le but de faciliter et d'améliorer les résultats des étapes ultérieures de la transformation.

D'autres caractéristiques et avantages de l'invention apparaitront au cours de la description qui va suivre d'exemples de mise en oeuvre de l'invention, donnés uniquement à titre non limitatif.

La figure 1 est un graphique représentant la tenue en corrosion d'une tôle d'acier zinguée en fonction de la quantité de chrome déposée.

La figure 2 montre une mire transparente agencée pour l'examen de l'aspect d'une tôle revêtue conformément à l'invention.

Le traitement de surface selon l'invention s'applique à des pièces métalliques, comme par exemple des tôles d'acier, revêtues de zinc ou d'alliage de zinc par galvanisation à chaud ou électrodéposition.

Le traitement de surface selon l'invention peut s'appliquer aux tôles d'acier galvanisées alliées.

Une tôle d'acier galvanisée alliée est obtenue de manière classique par immersion de la bande de tôle d'acier dans un bain de zinc en fusion, et par traitement thermique de la tôle ainsi revêtue.

A la suite du traitement thermique, une partie du fer du substrat diffuse dans la couche de revêtement de zinc, de sorte que celle-ci contienne après traitement une teneur en fer de l'ordre de 10%. L'épaisseur de la couche ainsi formée est par exemple égale à 6,5 µm. On dépose alors sous vide sur au moins une face de la tôle d'acier galvanisée alliée un film mince de chrome d'épaisseur comprise entre 0,01 et 1 µm, et par exemple égale à 0,085 µm.

Conformément à l'invention, on dépose sous vide sur au moins une face d'une tôle d'acier revêtue de zinc ou d'alliage de zinc, un film mince de chrome ou d'alliage de chrome appelé flash.

L'alliage de chrome peut être du Cr-Si ou du Cr-Ni.

La tôle d'acier, d'épaisseur 0,5 à 1 mm est par exemple revêtue de manière classique par électrodéposition d'une couche de zinc d'épaisseur 5 à 10 µm sur chacune de ses faces.

Le dépôt de chrome ou d'alliage de chrome sous vide peut être réalisé par voie physique, suivant l'une des techniques connues sous le sigle PVD (Physical Vapor Deposition).

On opère de préférence par pulvérisation ionique et par exemple par pulvérisation cathodique magnétron.

Le dépôt peut être également effectué par évaporation afin d'atteindre des vitesses de dépôt compatibles avec les vitesses de défilement d'une ligne industrielle. Le terme évaporation correspond également dans la suite du texte au phénomène de sublimation.

Lorsqu'on opère par évaporation sous vide, on réalise un tel dépôt de chrome ou d'alliage de chrome dans une enceinte sous vide dont l'atmosphère est à une pression comprise entre 10⁻⁴ et 10²Pa, de préférence comprise entre 10⁻³ et 10⁻¹Pa, et par exemple égale à 5.10⁻³Pa.

Le matériau à évaporer est contenu sous forme solide ou en poudre, dans un creuset métallique ou céramique et est chauffé au moyen d'un système de chauffage par exemple par effet Joule, par induction ou par un dispositif de chauffage par bombardement électronique. Dans le cas du flash de chrome, un dispositif de chauffage par induction est utilisé. Par contre, pour un alliage de Cr-Si ou Cr-Ni, un dispositif d'évaporation avec canon à électrons est mieux adapté.

La largeur du creuset d'évaporation ou de la ligne de creusets d'évaporation doit être supérieure à la largeur de la tôle et par exemple pour une largeur de bande de 1 mètre, le dispositif d'évaporation doit avoir une largeur supérieure ou égale à 1,15 mètre.

Les atomes ou groupements d'atomes du matériau évaporé, à savoir le chrome ou un alliage de chrome vont, après évaporation, se condenser sur la surface de la tôle d'acier zinguée afin de former un flash de chrome d'épaisseur inférieure ou égale à 1 µm, et par exemple égale à 0,5 µm.

Le temps d'exposition de la tôle d'acier à l'atmosphère gazeuse de chrome dépend évidemment de l'épaisseur de flash souhaitée.

Suivant une forme de réalisation avantageuse de l'invention, préalablement au dépôt du film mince de chrome, on soumet la surface de la tôle d'acier à un prénettoyage par bombardement ionique dans au moins un gaz neutre (Ar, Xe, Kr) ou dans au moins un gaz réactif (O₂, F₂, H₂, N₂, un hydrocarbure volatil) ou dans un mélange d'au moins un gaz neutre et d'au moins un gaz réactif.

Par exemple, la surface de la bande de tôle d'acier est soumise à un prénettoyage par bombardement ionique avec des ions d'argon.

Les énergies des ions doivent être comprises entre 200 et 2000 eV, par exemple 500 eV, et les densités de courants ioniques recueillis sont comprises entre 0,1 et 1 mA/cm², et par exemple égales à 0,8 mA/cm².

Ce prétraitement qui ne doit pas être excessivement long et, en général ne doit pas dépasser 3 minutes afin de ne pas chauffer la bande à une température supérieure à 200°C, améliore l'adhérence du film de chrome sur ladite bande.

Suivant une autre caractéristique avantageuse, possible de l'invention, on réalise simultanément au dépôt du film de chrome un bombardement ionique de la surface de la bande de tôle d'acier à partir d'un gaz ou d'un mélange gazeux formé d'au moins un gaz neutre (Ar, Xe, Kr), ou d'au moins un gaz réactif (O₂, F₂, H₂, N₂, un hydrocarbure volatil) ou à partir d'un mélange d'au moins un gaz neutre et d'au moins un gaz réactif.

Ces gaz peuvent être différents de ceux utilisés pour la phase de prénettoyage ionique, et le mélange gazeux utilisé est par exemple un mélange d'argon et de 25% de CH₄, ou d'argon et oxygène.

Les énergies et densités de courants ioniques pour cette phase sont du même ordre de grandeur que celles de la phase de prénettoyage ionique et sont par exemple respectivement égales à 500 eV et 0,4 mA/cm².

Il faut toutefois mentionner que ces paramètres doivent être ajustés de manière à éviter une évaporation du zinc lors de la formation du flash. Cette phase de bombardement ionique simultanée au dépôt du flash permet d'obtenir un revêtement de chrome très dense et peut permettre en outre, l'obtention d'un dépôt céramique de chrome (oxyde, nitrure, carbure...).

Lorsque le dépôt de chrome ou d'alliage de chrome est effectué par pulvérisation ionique, notamment par pulvérisation cathodique magnetron, l'opération est conduite dans une enceinte sous vide dans laquelle la pression gazeuse est comprise entre 5.10⁻² et 1 Pa, de préférence entre 10⁻¹ et 5.10⁻¹ Pa.

Lors de la pulvérisation cathodique dans l'enceinte sous vide, le matériau à déposer, à savoir le chrome ou l'alliage de chrome, joue le rôle d'une cathode et la tôle à revêtir joue le rôle d'une anode.

La densité de puissance électrique utilisée est avantageusement comprise entre 1 et 30 N/cm² de la surface de la cathode et est par exemple égale à 5,33 N/cm².

On forme un plasma ionique dans l'enceinte sous vide contenant au moins un gaz neutre ou au moins un gaz réactif ou un mélange gazeux formé d'au moins un gaz neutre et au moins un gaz réactif et les ions constituant ce plasma pulvérisent les atomes de la cathode qui viennent alors se déposer sur l'anode.

Par exemple, on peut déposer un revêtement de chrome sur une tôle en acier galvanisé allié par pulvérisation cathodique magnetron de la façon suivante :

Un plasma d'argon est créé dans l'enceinte de pulvérisation sous vide contenant une plaque de chrome servant de cathode, et les ions constituant ce plasma pulvérisent les atomes de chrome de la plaque, qui viennent alors se déposer sur la tôle d'acier galvanisée alliée en mouvement. Le plasma utilisé est un plasma radiofréquence à 13,56 MHz. L'espace entre les électrodes est de 8,2 cm et la vitesse de dépôt est de 0,11 µm/mn.

Dans le cas où l'on opère par pulvérisation ionique, on peut également de manière avantageuse soumettre la ou les faces de la tôle à revêtir, préalablement au dépôt du flash de chrome, à un prénettoyage par bombardement ionique dans au moins un gaz neutre ou au moins un gaz réactif ou dans un mélange gazeux formé d'au moins un gaz neutre et au moins un gaz réactif, la durée de ce bombardement ionique ne dépassant pas 4 mn.

Le gaz neutre peut être choisi comme précédemment parmi le groupe (Ar, Xe, Kr) et le gaz réactif peut être choisi parmi le groupe (O₂, F₂, H₂, N₂, un hydrocarbure volatil). Dans l'exemple décrit, le prénettoyage ionique peut être réalisé avec de l'oxygène.

Le traitement de surface selon l'invention présente l'avantage de supprimer toute pollution de l'environnement, notamment par les ions chromates, tout en conférant à la surface de la pièce métallique zinguée ainsi traitée une protection efficace contre l'action corrosive du milieu extérieur, en retardant l'apparition du phénomène de la rouille rouge.

L'utilisation du traitement de surface selon l'invention peut s'appliquer en particulier à des tôles en acier zinguées non alliées pour améliorer leur résistance à la corrosion.

Le traitement de surface selon l'invention apporte de nombreux autres avantages :
- une tôle d'acier revêtue de zinc ou d'alliage de zinc et traitée selon l'invention possède un coefficient de frottement plus faible qu'une tôle non traitée, ce qui permet de faciliter l'opération ultérieure de mise en forme de ladite tôle. L'invention procure donc un procédé de mise en forme d'une tôle en acier révêtu de zinc ou d'alliage de zinc dans lequel, avant l'étape de mise en forme proprement dite, on prépare ladite tôle par un traitement de surface tel que décrit précédemment.
- la surface d'une telle tôle d'acier est plus dure que celle d'une tôle d'acier simplement revêtue de zinc ou d'alliage de zinc.
- l'adhérence d'un revêtement organique sur une tôle d'acier revêtue de zinc ou d'alliage de zinc et traitée selon l'invention est très satisfaisante.
- lors du soudage des tôles d'acier zinguées traitées selon l'invention, on observe que le flash de chrome ou d'alliage de chrome ne pollue pas les électrodes de soudage, alors que cela reste un inconvénient avec le zinc.

La Demanderesse s'est aperçue de manière tout à fait inattendue qu'un dépôt sous vide d'un flash de chrome ou d'alliage de chrome d'épaisseur inférieure ou égale à 1µm sur une pièce, notamment une tôle, en acier galvanisé allié, permettait également d'éviter l'apparition du phénomène de cratérisation.

Ce phénomène apparait généralement après l'étape de cataphorèse lors de la mise en peinture de la pièce, et se caractérise par des défauts de surface ayant notamment l'apparence de petits cratères, et qui restent visibles malgré l'étape de finition ultérieure, au cours de laquelle un apprêt et une laque sont appliqués sur la pièce.

Une tôle ainsi marquée est alors inacceptable pour des applications telles que les carrosseries de véhicules automobiles, en raison de son aspect inesthétique.

Par ailleurs, ces défauts affectent de manière significative la résistance à la corrosion atmosphérique des tôles d'acier galvanisées alliées.

Ce traitement de surface selon l'invention de tôles d'acier galvanisées alliées permet également d'améliorer l'aspect de ces tôles après leur mise en peinture.

L'invention a ainsi également pour objet un procédé de mise en peinture de pièces métalliques, notamment de tôles en acier, revêtues de zinc ou d'alliage de zinc dans lequel, avant l'étape de mise en peinture proprement dite, lesdites pièces sont soumises à un traitement préparatoire de dépôt de chrome ou d'alliage de chrome tel que décrit précédemment.

La mise en peinture peut se faire selon tout procédé connu, en particulier par cataphorèse.

Un tel procédé de mise en peinture s'applique à toute pièce revêtue de zinc ou d'alliage de zinc et est particulièrement avantageux pour la mise en peinture de tôles en acier zingué allié.

Les essais décrits ci-après vont illustrer les différentes propriétés de tôles d'acier zinguées traitées selon l'invention et les avantages qui en découlent.

### Essai 1

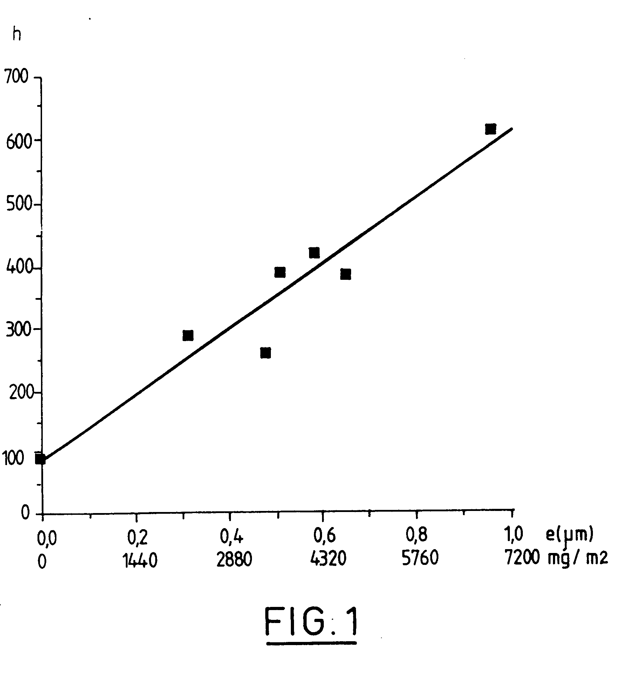

La figure 1 annexée illustre des résultats de tests de corrosion d'une tôle d'acier revêtue de zinc par électrodéposition et ayant subi un traitement de surface par dépôt de chrome par évaporation sous vide conformément à l'invention.

Des échantillons de tôles d'acier ont été revêtus par électrodéposition d'une couche de zinc de 7,5 µm d'épaisseur et la surface des tôles ainsi revêtue a été soumise à un prénettoyage par bombardement ionique dans les conditions suivantes.
gaz : argon
énergie des ions : 500 eV
densité de courant ionique : 0,4 mA/cm²

Durant les dépôts de flash de chrome qui sont effectués dans une enceinte soumise à une pression de 4.10⁻¹ Pa sur les échantillons ainsi préparés, on soumet leur surface à un bombardement ionique dans les conditions suivantes :
gaz : argon
énergie des ions : 500 eV
densité de courant ionique : 0,4 mA/cm²

Après le dépôt du flash, les tôles ont été soumises à un test appelé test de brouillard salin, effectué selon la norme NF X 41-002, qui a consisté à soumettre les échantillons de tôle d'acier zingué traités à une atmosphère saline de concentration environ égale à 50 g/l.

Ainsi, on a représenté en abscisses l'épaisseur du film de chrome des différents échantillons et en ordonnées le temps (en heures) au bout duquel on observe le début d'apparition de la rouille rouge sur lesdits échantillons.

Les performances obtenues sont très supérieures à celles d'une tôle d'acier revêtue uniquement de zinc et, à performances équivalentes, permettent donc de diminuer substantiellement l'épaisseur du revêtement de zinc sous le film mince de chrome, réalisant ainsi un gain économique important.

Ainsi, le traitement de surface selon l'invention permet de lutter efficacement contre l'apparition de la rouille rouge, ce que ne fait pas un traitement de chromatation ou d'électrochromage.

### Essai 2

Des échantillons de tôles d'acier sont revêtus de manière classique par électrodéposition d'une couche de zinc d'épaisseur égale à 8,4 µm. On soumet la surface des échantillons à un prénettoyage par bombardement ionique dans les conditions suivantes :
gaz : argon
énergie des ions : 500 eV
densité de courant ionique : 0,4 mA/cm²

Deux échantillons 1 et 2 sont revêtus d'un film de chrome d'épaisseur égale à 0,48 µm, et deux échantillons 3 et 4 sont revêtus d'un film de chrome d'épaisseur égale à 0,65 µm par évaporation de chrome dans une enceinte soumise à une pression de 4.10⁻¹ Pa.

Simultanément aux dépôts de ces films minces de chrome on soumet la surface des échantillons à un bombardement ionique dans les conditions suivantes :
gaz : argon
énergie des ions : 500 eV
densité de courant ionique : 0,4 mA/cm²

On fait subir aux échantillons 2 et 4 une traction suivant leur longueur, correspondant à un taux de déformation de 5%.

Ensuite, les quatre échantillons sont soumis au test du brouillard salin conformément à la norme NFX41-002 et l'on a répertorié dans le tableau suivant le temps (en heures) au bout duquel le début d'apparition de la rouille rouge est observé :

| Echantillon | Temps d'apparition de la rouille rouge (h) |
|---|---|
| 1 | 260 |
| 2 | 260 |
| 3 | 386 |
| 4 | 300 |

Ainsi, il est surprenant de constater que les performances des échantillons de tôles d'acier zingué traités restent comparables, même dans le cas où les films de chrome de ces échantillons sont fissurés après le test de déformation.

### Essai 3

Des échantillons de tôles d'acier sont revêtus de manière classique par électrodéposition d'une couche de zinc d'épaisseur égale à 8,4 µm.

On soumet la surface de ces échantillons à un prénettoyage par bombardement ionique dans les conditions suivantes :
gaz : argon
énergie des ions : 500 eV
densité de courant ionique : 0,4 mA/cm²

Un film mince de chrome d'épaisseur 0,35 µm est déposé sur chacun des échantillons et, simultanément au dépôt, on soumet la surface de ces échantillons à un bombardement ionique dans les conditions suivantes
gaz : argon
énergie des ions : 500 eV
densité de courant ionique : 0,4 mA/cm²

Le dépôt sous vide est effectué par évaporation de chrome dans une enceinte soumise à une pression de 4.10⁻¹ Pa. Les échantillons ainsi préparés sont soumis au test de flexion 3 points conformément à la notre NF-T30010, et les forces mesurées sont répertoriées dans le tableau suivant ainsi que le mode de rupture constaté pour chaque échantillon :

| Echantillon | F(N) | Mode de rupture |
|---|---|---|
| 1 | 166 | cohésive dans le joint de colle |
| 2 | 176 | cohésive dans le joint de colle |
| 3 | 194 | cohésive dans le joint de colle |
| 4 | 172 | cohésive dans le joint de colle |
| 5 | 197 | cohésive dans le joint de colle |

Ce test a permis de révéler que la rupture observée après application d'une force donnée avait toujours lieu dans le joint de colle et était cohésive.

Les flashes de chrome sous vide possèdent donc une très bonne adhérence puisque les forces d'adhérence sont estimées supérieures à 150 N.

### Essai 4

Cinq échantillons de tôles d'acier sont revêtus de manière classique par électrodéposition d'une couche de zinc d'épaisseur égale à 8,4 µm. On soumet la surface des échantillons à un prénettoyage par bombardement ionique dans les conditions suivantes :
gaz : argon
énergie des ions : 500 eV
densité de courant ionique : 0,4 mA/cm²

On dépose alors sur les échantillons un film mince de chrome d'épaisseur égale à 0,58 µm, par évaporation de chorme dans une enceinte sous vide soumise à une pression de 4.10⁻¹ Pa et, simultanément, on procède à un bombardement ionique des surfaces à revêtir dans les conditions suivantes :
gaz : argon
énergie des ions : 500 eV
densité de courant ionique : 0,4 mA/cm²

Les échantillons sont ensuite revêtus d'une résine époxydique. Le poids de la couche de résine organique est d'environ 1000 mg/m². Les échantillons ainsi revêtus sont soumis au test de flexion 3 points conformément à la norme NF-T30010, et les forces mesurées pour rompre les échantillons figurent dans le tableau ci-dessous.

| Echantillon | F(N) | Mode de rupture |
|---|---|---|
| 1 | 146 | cohésive dans le joint de colle |
| 2 | 149 | cohésive dans le joint de colle |
| 3 | 153 | cohésive dans le joint de colle |
| 4 | 158 | cohésive dans le joint de colle |
| 5 | 158 | cohésive dans le joint de colle |

Ainsi ce test a permis de mettre en évidence que l'adhérence d'un revêtement organique sur un flash de chrome déposé sous vide offre de très bons résultats, les forces d'adhérence étant estimées supérieures à 150 N.

### Essai 5

Cet essai vise à illustrer à travers un test de frottement la facilité de mise en oeuvre d'une tôle d'acier électrozinguée revêtue d'un flash de chrome, par le traitement de surface selon l'invention.

L'essai est réalisé sur deux échantillons de tôle d'acier électrozinguée notées 1 et 2, dont le revêtement de zinc est obtenu de manière classique par électrodéposition et forme une couche de 7,5 µm d'épaisseur.

Sur chacune des faces à revêtir de ces échantillons, on procède à un prénettoyage par bombardement ionique dans les conditions suivantes :
gaz : argon
énergie des ions : 500 eV
densité de courant ionique : 0,4 mA/cm²

Par évaporation de chrome dans une enceinte sous vide soumise à une pression de 5.10⁻³ Pa, on dépose sur chaque surface de l'échantillon 2 préalablement nettoyée un film mince de chrome d'épaisseur égale à 0,27 µm.

Le test de frottement consiste à placer chacun des échantillons verticalement entre deux outils qui exercent sur chacun d'eux, au moyen d'un vérin hydraulique, un effort de serrage variable simulant le contact avec un serre flan et une matrice, au cours d'une opération d'emboutissage.

Simultanément, les échantillons sont tirés verticalement vers le haut à vitesse constante égale à 0,1 m/mn et avec une force proportionnelle à l'effort d'emboutissage au moyen d'un autre vérin hydraulique.

Pour chaque échantillon, on mesure à chaque pression d'emboutissage le coefficient de frottement entre ledit échantillon et les outils.

L'échantillon 1 possède un coefficient de frottement initial de 0,16 qui augmente à partir d'une pression d'emboutissage égale à 150 bars, représentant un début de grippage, jusqu'à une pression égale à 400 bars, pour laquelle le coefficient de frottement est de 0,25.

Le coefficient de frottement initial de l'échantillon 2 est le même que pour l'échantillon 1 mais le phénomène d'apparition du grippage ne débute que pour une pression d'emboutissage de 250 bars, et reste d'amplitude plus modérée puisque le coefficient de frottement est de 0,22 pour une pression de 400 bars.

Par conséquent, le frottement d'une tôle d'acier zinguée revêtue d'un flash de chrome par dépôt sous vide est facilitée, d'une part, par le retardement de l'apparition du phénomène de grippage et, d'autre part, par la diminution du coefficient de frottement lors de son apparition.

### Essai 6

L'essai a pour but de montrer la résistance au phénomène de cratérisation des tôles d'acier galvanisées alliées revêtues d'un flash de chrome selon l'invention lors de l'opération de cataphorèse.

L'essai est effectué sur deux échantillons de tôles d'acier galvanisées alliées obtenues de manière classique par immersion des échantillons dans un bain de zinc en fusion et par traitement thermique desdits échantillons. On obtient sur chaque échantillon une épaisseur de revêtement de l'ordre de 6,5 µm, la teneur en fer du revêtement étant voisine de 10% et l'épaisseur de la tôle d'acier avant revêtement étant de 0,7 mm.

On dispose de sept échantillons numérotés de 1 à 7, l'échantillon 1 servant de témoin.

Chacun des six échantillons 2 à 7 est placé dans une enceinte sous vide et constitue une anode, la cathode étant constituée par une plaque de chrome fixe de 30cm x 12,5cm. Préalablement, on soumet les faces à revêtir des échantillons à un prénettoyage par bombardement ionique à l'oxygène.

L'espace entre les électrodes est de 8,2cm.

On crée un plasma d'argon qui est un plasma radiofréquence à 13,56 MHz et dont la pression gazeuse est égale à 4.10⁻¹Pa.

La densité de puissance électrique utilisée est de 5,33 W/cm² de la surface de la cathode.

On vient ainsi déposer par pulvérisation cathodique magnétron sur chacun des six échantillons 2 à 7 un film mince de chrome d'épaisseur respectivement égale à 0,05 µm, 0,085 µm, 0,17 µm, 0,34 µm, 0,68 µm et 1 µm.

Ensuite, on effectue sur les échantillons 1 à 7 diverses opérations largement connues de l'art antérieur : dégraissage alcalin, rinçage, affinage, phosphatation tricationique, rinçage, étuvage.

Les échantillons sont ensuite soumis à une opération de cataphorèse de type PPG ED4 717/958 permettant d'appliquer une première couche de peinture d'épaisseur égale à 20 µm sur chacun d'eux.

L'essai pratiqué sur tous les échantillons consiste, lors de l'opération de cataphorèse, à appliquer différentes tensions électriques à l'électrolyte et à relever, pour chaque tension appliquée, le nombre de cratères par cm² apparaissant sur les échantillons.

Ainsi, pour l'échantillon 1, lors de l'application d'une tension de 250 V environ, 1 à 5 cratères par cm² apparaissent, et ce nombre croît jusqu'à 50 par cm² pour une tension appliquée de 330 V.

Par contre, pour une tension allant de 250 à 330 V, aucun phénomène de cratérisation n'apparait sur les six échantillons 2 à 7.

### Essai 7

Le but de cet essai est de montrer l'amélioration de l'aspect d'une tôle d'acier galvanisée alliée revêtue d'un flash de chrome, après sa mise en peinture par rapport à l'aspect d'une tôle d'acier galvanisée alliée et peinte. Cet essai consiste à mesurer le DOI de sept échantillons de tôle d'acier identiques et préparés dans les mêmes conditions que lors de l'essai 6.

Ces échantillons reçoivent une couche d'apprêt de 45µm d'épaisseur puis après cuisson, reçoivent une couche de laque de 45µm d'épaisseur et subissent une dernière cuisson.

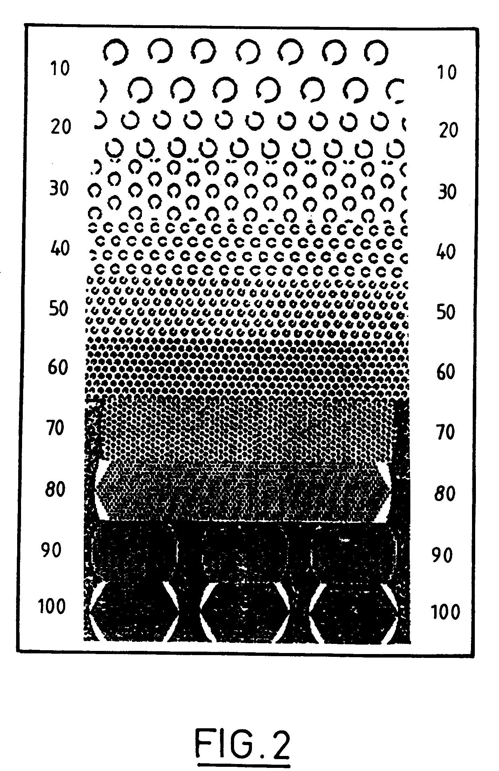

Le DOI (Distinctness of image) révèle l'aptitude d'une surface à réfléchir des images plus ou moins nettes et sa mesure prend en compte la tension et le brillant du film de peinture. Pour effectuer la mesure du DOI des surfaces peintes des échantillons 1 à 7, on utilise un appareil commercialisé par la société CHIMILAB ESSOR et comportant une mire transparente (Fig.2) sur laquelle sont représentés des anneaux ouverts répartis en plusieurs zones parallèles juxtaposées : la première de ces zones est occupée par plusieurs anneaux identiques de diamètre élevé et une cotation 10 est figurée en regard de cette zone. Ainsi, de proche en proche, les zones suivantes sont occupées par des anneaux identiques de diamètre de plus en plus réduit, auxquelles correspondent respectivement des cotations de plus en plus élevées par saut de 10 et allant jusqu'à 100.

Ainsi, pour chaque échantillon, on projette l'image de la mire sur l'une des faces de celui-ci à l'aide d'une lumière, et l'opérateur effectuant l'essai donne une cotation correspondant au plus petit anneau parfaitement visible lorsqu'il observe la surface peinte sous un angle d'incidence de 30°.

Les résultats de l'essai montrent une cotation de 80 pour l'échantillon 1 et une cotation de 85 pour les six autres échantillons, prouvant par là même l'amélioration de l'aspect des tôles d'acier galvanisées alliées traitées selon l'invention après leur mise en peinture.

## Revendications

1. Traitement de surface de pièces métalliques, telles que des tôles d'acier revêtues de zinc ou d'alliage de zinc, caractérisé en ce que l'on dépose sous vide sur au moins une face de la pièce métallique un film mince de chrome ou d'alliage de chrome, d'épaisseur au plus égale à 1µm.

2. Traitement de surface selon la revendication 1, caractérisé en ce que le dépôt sous vide est effectué par voie physique.

3. Traitement de surface selon les revendications 1 et 2, caractérisé en ce que le dépôt sous vide est effectué par évaporation de chrome ou d'alliage de chrome.

4. Traitement de surface selon la revendication 3, caractérisé en ce que l'évaporation de chrome ou d'alliage de chrome est provoquée par chauffage par effet Joule, induction ou bombardement électronique.

5. Traitement de surface selon l'une des revendications 1 à 4, caractérisé en ce que simultanément au dépôt du film mince de chrome ou d'alliage de chrome, on procède à un bombardement ionique de ladite face de la pièce métallique, dans un gaz contenant au moins un gaz neutre ou au moins un gaz réactif ou dans un mélange gazeux formé d'au moins un gaz neutre et au moins un gaz réactif.

6. Traitement de surface selon la revendication 2, caractérisé en ce que le dépôt sous vide de chrome ou d'alliage de chrome est effectué par pulvérisation ionique.

7. Traitement de surface selon la revendication 6, caractérisé en ce que le dépôt sous vide est effectué par pulvérisation cathodique magnétron de chrome ou d'alliage de chrome.

8. Traitement de surface selon la revendication 7, caractérisé en ce que la pulvérisation cathodique magnétron utilise une densité de puissance électrique comprise entre 1 et 30 W/cm² de la surface de la cathode.

9. Traitement de surface selon l'une des revendications 6 à 8, caractérisé en ce que le dépôt sous vide est réalisé dans un gaz ou au moins un gaz réactif ou dans un mélange gazeux formé d'au moins un gaz neutre et au moins un gaz réactif.

10. Traitement de surface selon l'une des revendications 1 à 9, caractérisé en ce que préalablement au dépôt du film mince de chrome ou d'alliage de chrome, on soumet ladite face de la pièce métallique à un bombardement ionique dans un gaz ou au moins un gaz réactif ou dans un mélange gazeux formé d'au moins un gaz neutre et au moins un gaz réactif.

11. Traitement de surface selon l'une des revendications 5, 9 et 10, caractérisé en ce que le gaz neutre est choisi parmi le groupe (Ar, Xe, Kr).

12. Traitement de surface selon l'une des revendications 5, 9 et 10, caractérisé en ce que le gaz réactif est choisi parmi le groupe (O₂, F₂, H₂, N₂, un hydrocarbure volatil).

13. Pièce métallique, telle qu'une tôle d'acier, revêtue de zinc ou d'alliage de zinc obtenue par le traitement de surface selon l'une des revendications 1 à 12, caractérisée en ce que ladite pièce métallique comporte sur au moins une face un film de chrome ou d'alliage de chrome d'épaisseur au plus égale à 1 µm.

14. Pièce métallique selon la revendication 13, caractérisée en ce que l'épaisseur du film mince de chrome ou d'alliage de chrome est supérieure ou égale à 0,01 µm.

15. Utilisation du traitement de surface selon la résistance à la corrosion de pièces métalliques en acier revêtues de zinc ou d'alliage de zinc.

16. Utilisation selon la revendication 15, dans laquelle ladite pièce est en acier zingué non allié.

17. Procédé de mise en forme de pièces métalliques, telles que des tôles en acier, revêtues de zinc ou d'alliage de zinc dans lequel, avant l'étape de mise en forme proprement dite, on prépare ladite pièce par un traitement de surface selon l'une quelconque des revendications 1 à 12.

18. Procédé de mise en peinture de pièces métalliques, telles que des tôles en acier, revêtues de zinc ou d'alliage de zinc dans lequel, avant l'étape de mise en peinture proprement dite, lesdites pièces sont soumises à un traitement de surface selon l'une quelconque des revendications 1 à 12.

19. Procédé selon la revendication 18, dans lequel la mise en peinture est effectuée par cataphorèse.

20. Procédé selon la revendication 18 ou 19, dans lequel ladite pièce est en acier zingué allié.
